# EUROPEAN PATENT SPECIFICATION

(11) **EP 4 254 803 B1**
(45) Date of publication and mention of the grant of the patent: **06.05.2026**
(21) Application number: 23179008.0
(22) Date of filing: 09.07.2019
(51) Int. Cl.: H04L 25/02, G08C 19/00, H03K 4/50, H03K 19/0185

(54) **DIGITAL ISOLATOR**
DIGITALER ISOLATOR
ISOLATEUR NUMÉRIQUE

(30) Priority: 10.07.2018 EP 18182754
(43) Date of publication of application: 04.10.2023
(62) Divisional of application: 19736393.0
(73) Proprietor: Navitas Semiconductor Limited, Dublin, D02 FH68 (IE)
(72) Inventor: DESSARD, Vincent, 1435 Mont-Saint-Guibert (BE)
(74) Representative: Debled, Thierry

(56) References cited:
- US-A- 6 144 326
- US-A1- 2012 161 841
- US-A1- 2016 126 724

## Description

### Field of the invention

The present invention generally relates to the field of capacitive isolation links.

The invention relates to the field of capacitive isolation systems for use in isolating electrical circuits from one another while transmitting digital information data. More particularly, this invention relates to isolation systems having capacitor-coupled isolation barriers. This is useful in, for example, industrial process control application, telephony, medical electronics, data communication.

### Description of prior art

Isolators are generally implemented to separate circuits or circuit sections of the electrical circuit to one another from undesired influence of, as for example but not limiting, other circuits or circuit sections, to minimize the influence of common mode transients (CMT), influence of radiation or electromagnetic interferences, cross talk, between circuits or circuit sections. Capacitive isolation links are also used to minimize the transmission of interferences introduced by the environment from one circuit to another or from one section of a circuit to one another. It is also used in galvanic isolation, to isolate high voltages from one another or to isolate low voltage command circuits to high voltage power circuits. Capacitive isolation links also allow better integration compared to other systems based for example on electromagnetic isolators.

Capacitive isolation links usually make use of a dielectric in order to block direct current between isolated circuits sections of the electrical circuits or to block lowest-frequency currents between the circuits sections while allowing transfer of a higher frequency data signal. The isolation barrier usually includes one or more capacitors or transformers. For this reason, information data shape commonly used is square signals with very fast transients used for the edges of the signal followed by a maintained information level (no transient information) allowing to transmit only the edge variation of the signal through the capacitive barrier.

Nevertheless, common mode transients (CMT) may be caused either as a result of different supply voltages and grounds that are present at different circuits or circuits sections or as the result of external interferences such as for example, radiation, electromagnetic fields, temperature variation. As a consequence, high frequency transients can corrupt the data transmission of a data signal across the isolation barrier. It is well known that addressing the effect of the CMT in a digital isolator is a challenge in designing such digital isolators.

Document SLLA284A "Digital Isolator Design Guide" from Texas Instrument, discloses capacitive isolation link devices including at least two data channels: a high-frequency channel (HF) with a bandwidth generally from 100kbps up to 150Mbps, and a low-frequency channel (LF) covering the range below down to dc. In principle, a single-ended input signal entering the HF-channel is split into a differential signal via the inverter gate at the input. The following capacitor-resistor networks differentiate the signal into small and narrow transients, which then are converted into rail-to-rail differential pulses by two comparators. The comparator outputs drive a NOR-gate flip-flop whose output feeds an output multiplexer. A decision logic (DCL) at the driving output of the flip-flop measures the durations between signal transients. If the duration between two consecutive transients exceeds a certain time limit (as in the case of a low-frequency signal) the DCL forces the output-multiplexer to switch from the high-frequency to the low-frequency channel. Because low-frequency input signals require the internal capacitors to assume prohibitively large values, these signals are pulse-width modulated (PWM) with the carrier frequency of an internal oscillator, thus creating a sufficiently high frequency, capable of passing the capacitive barrier. As the input is modulated, a low-pass filter (LPF) is needed to remove the high-frequency carrier from the actual data before passing it on to the output multiplexer.

Document US2017/0302225A1 discloses a system where the input circuit includes an on-off keying (OOK) modulator configured to generate a modulated data signal in response to the input data signal and the carrier signal. The output circuit includes a frequency shift keying (FSK) demodulator configured to detect a presence of the carrier signal in the modulated differential data signal and generate a demodulated data signal in response to the presence of the carrier signal.

Document EP0973305A1 discloses a capacitive insulating barrier system with a sawtooth signal as a carrier to generate a Pulse Width Modulation (PWM) signal as an input signal of the capacitive insulation barrier. There are two capacitors between input and output circuit which provide isolation between input and output circuits. A square pulse width modulated signal is used as transmitted signal from one side of the isolation barrier to the other.

Conventional capacitive links cannot transmit states but only transients such that when using a single capacitor, the system cannot make the difference between a parasitic and a transition of the data state to be transmitted. Therefore, two capacitors are used to transmit data on a differential way so that the unwanted parasitic can be removed. But using only 2 capacitors directly with the signal to be transmitted is risky. Indeed, in case of wrong communication for any reason such as described previously, the output signal can be stated in the wrong state and could theoretically remain in the wrong state for long time until some correction can be made or until a new state to be transmitted is defined. This could lead to a fatal failure in some applications. For this reason, many designs include a second pair of capacitors that is intended to transmit a modulated version of the data signal instead of the data signal itself. With a modulated square data signal, there is always a state change so that the capacitive link will transmit it. In case of "wrong pulse", it will be promptly corrected at the next edge of the modulated signal so that no fatal failure can happen.

However, with this second channel, as the input signal is modulated with a carrier frequency that is either asynchronous or synchronous with the input signal, the modulated signal further needs to be demodulated. This adds delay and jitter. This can be critical or not, depending on the final application.

In the capacitive links, a square or sinusoidal signal is applied at the input of a capacitive link. In case of sinusoidal waves, a specific demodulator is required, leading to some delay and jitter. It can also require some magnetics to generate such waveforms. In case of square waves, the capacitor will always transmit a rising edge followed by a constant state and then by a falling edge. The capacitive link is a high pass filter. These solutions require a demodulator in the receiver circuit to extract the envelope of the signal. This involves some time constant, leading to additional delay and output jitter as well as extra demodulation or detection circuits that increase the system size and limits its integration.

### Summary of the invention

It is an object of the present invention to provide a circuit for transmitting a digital signal through a capacitive isolation link with reduced, limited and known delay and reduced or no jitter with only one differential link and without the use of a PWM or OOK modulator and then without the need for FSK demodulation in order to reduce the size of the circuit and favoring integration in very small volumes.

According to a first aspect, the invention provides a digital isolator according to claim 1. The present application defines thereby a digital isolator. The digital isolator of the invention comprises at least one logic module for receiving said digital signal D. Said at least one logic module, comprises a clock generator generating a clock signal CLK having a period T0 and, in a preferred embodiment, a pulse width shorter than T0/3.
Preferably, the durations of the slow rising edges and/or of the slow falling edges at said nodes A1 and/or A2 are at least two times, four times, or more preferably ten times the durations of the corresponding fast falling edges and/or fast rising edges, respectively. The duration of the slow or fast riding edges may be determined as being the time needed for reaching a ratio such as 80% of a power supply voltage. The duration of the slow or fast falling edges may be determined as being the time needed for falling down to a ratio such as 20% of a power supply voltage.

In an embodiment, hereafter referred to as "anti-jitter embodiment", said logic module may comprise means for disabling the clock generator at a transition of the digital signal D, and for re-enabling the clock generator after a delay larger than or equal to 0.8*T0 afterwards. This provides an anti-jitter solution.

### Short description of the drawings

In the drawings:

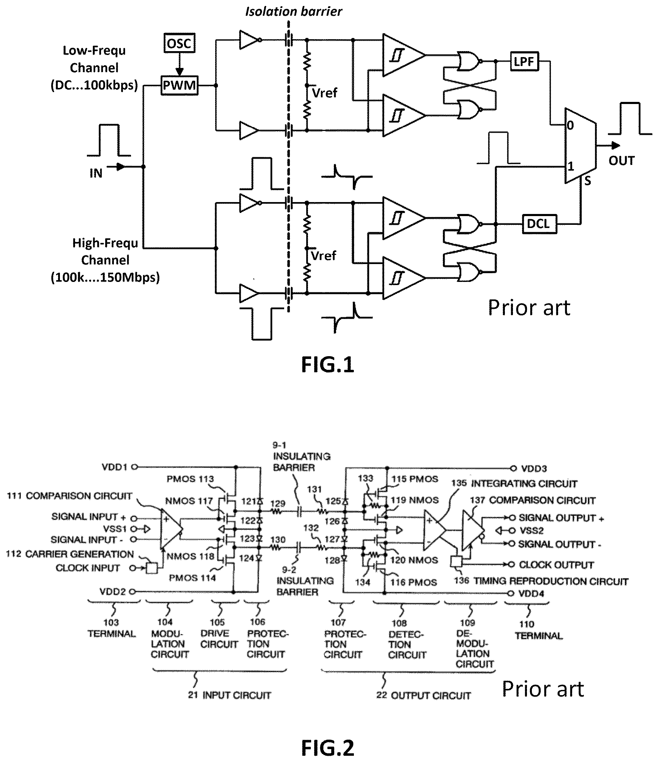

**Fig.1** is a conceptual block diagram of a known edge-based architecture of a digital isolator by Texas Instruments Incorporated from document SLLA284A.
**Fig.2** is the schematic of one CMOS technology implementation of known isolation coupler having a capacitive barrier. This figure is Fig.3 in document EP0973305A1.
   Further aspects of the invention will be explained in greater detail by way of examples and with reference to the accompanying drawings in which:
   **Fig.3a** is a block diagram of an isolator according to the invention,
   **Fig.3b** is a block diagram of an isolator according to the invention, comprising an SR latch;
   **Fig.4a** represents typical signals at nodes **A1** and **A2** of the isolator of Fig. 3a or 3b, in dependence of the clock signal **CLK,** when digital signal D equals 0;
   **Fig.4b** represents typical signals at specific nodes of the isolator of Fig. 3a or 3b.
   **Fig.5a, 5b,****5c** are embodiments of a logic module for use in a digital insulator according to embodiments of the invention,
   **Fig.6a** and **6b** represent embodiments of sawtooth modulators for use in a digital insulator according to an embodiment of the invention.
   **Fig.7** show results of simulation of the anti-jitter embodiment of the invention.

The drawings of the figures are neither drawn to scale nor proportioned.

### Detailed description of embodiments of the invention

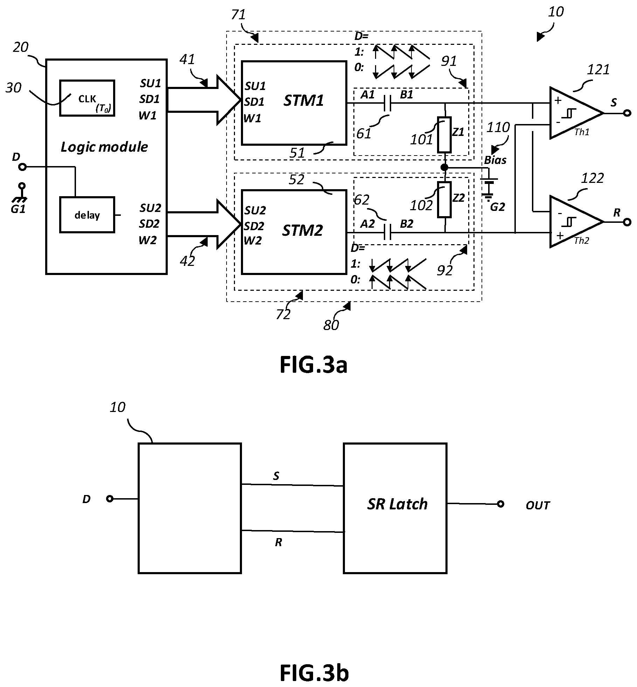

In **Fig.3a****,** depicts a block diagram of a digital isolator **10** according to the invention. The digital isolator **10** is for receiving a digital signal D, with reference to a first ground **G1,** and for providing corresponding output signals **S** and **R** with reference to a second ground **G2.** Signals **S** and **R** may for example be sent to an SR latch, as depicted on **Fig.3b****,** in order to regenerate said input signal **D** as signal **OUT.** Alternatively, signals **S** and **R** may be sent to low-pass filters or peak detectors in order to regenerate said input signal **D** as signal **OUT.**

A logic module **20** for receiving said digital signal D may comprise a clock generator **30** generating a clock signal CLK having a period **T0.** Said logic module is configured to provide command signals **(41, 42)** to at least one sawtooth modulator. Said logic module provides first command signals **41** and second command signals **42** to respectively sawtooth modulators STM1 **51** and STM2 **52,** in order to generate said sawtooth signals comprising a fast rising edge followed by a slow falling edge or a fast falling edge followed by a slow rising edge. A plateau may be present between a falling and a rising edge or between a rising and a falling edge. Said logic module can be also implemented in two parts, one for STM1 and one for STM2 at the condition that the same clock signal is used for both logic module blocks or that the signal clocks for the two blocks are synchronized.

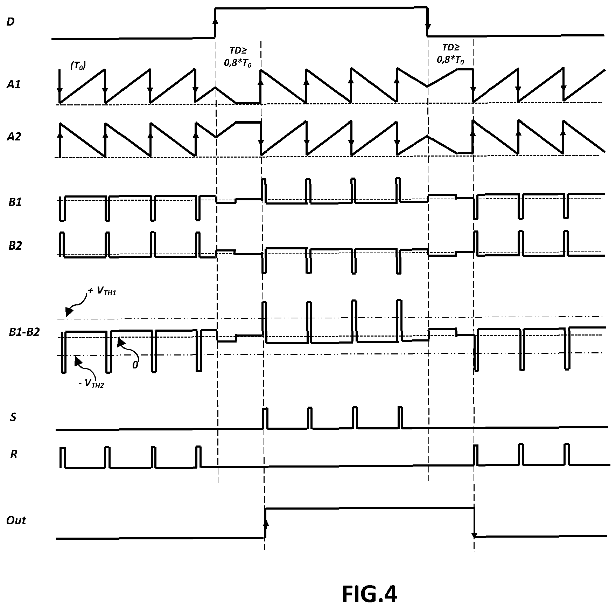

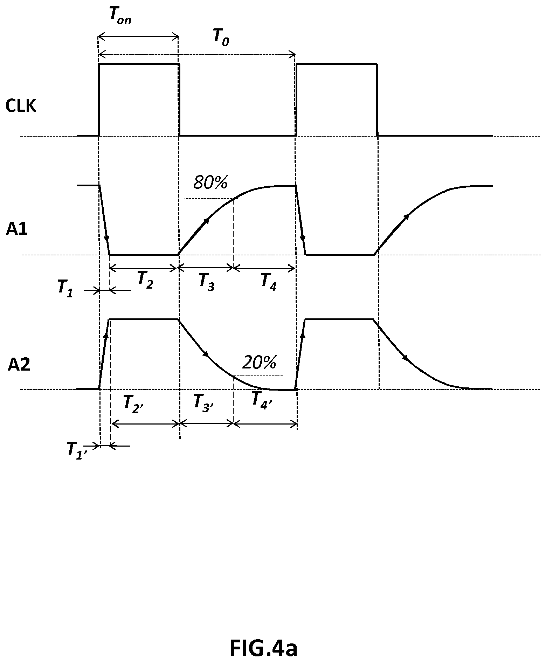

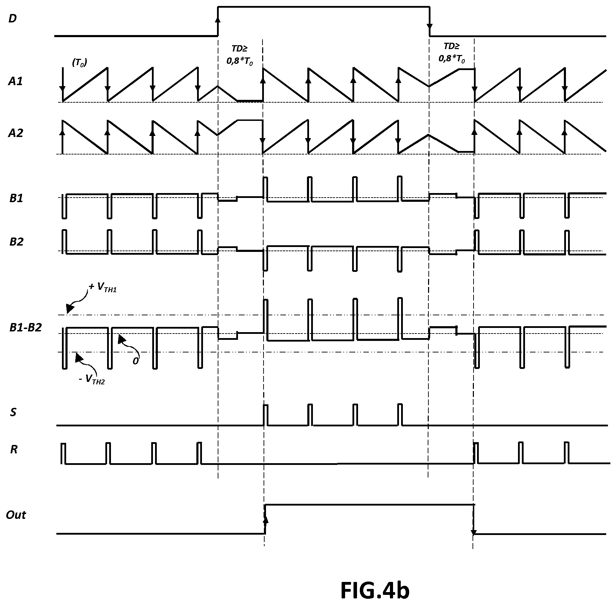

The invention is based on producing and transmitting through the isolation capacitors **61** and **62** of respectively first channel **71** and second channel **72** of the differential link **80,** specific shaped waveform that are called in the present disclosure sawtooth signals, sent to respectively the input node **A1** of the isolation capacitors **61** and the input node **A2** of the isolation capacitors **62.**
Signals at node **A1** comprise a sequence of fast rising edges followed by slow falling edges, when D equals 1, and a sequence of fast falling edges followed by slow rising edges when D equals 0.
Signals at node **A2** comprise a sequence of slow falling edges followed by fast rising edges when D equals 0, and a sequence slow rising edges followed by fast falling edges when D equals 1.
Signals at nodes **A1** and **A2** are also presented in **Fig.4a** and **Fig.4b****.** Edges of sawtooth signals may be either curves or linear segments.

Said node **A1** is the input node of the isolation capacitor **61** used for isolating the circuit sections of the system on a first channel **71** of the differential circuit **80.** Node **B1** is the second node of the said first isolation capacitor **61.** Node **B1** is used as output of the capacitive barrier. Said node **A2** is the input node of the isolation capacitor **62** used for isolating the circuit sections of the system on a second channel **72** of the differential circuit **80.** Node **B2** is the second node of the said second isolation capacitor **62.** Node **B2** is used as output of the capacitive barrier for the second channel **62** of the differential circuit.

As seen in **Fig.3a****,** the isolation capacitors **61** and **62** are also used as part of, respectively, high pass filters **91** and **92** together with impedances **101** and **102** both connected to the same bias voltage source **110** with reference to ground **G2.** High pass filters **91** and **92** allow to obtain respectively at each output nodes **B1** and **B2** of the isolation capacitors **61** and **62** successive peak pulses of same orientations while the data signal **D** remains constant as shown in **Fig.4b****.** To obtain such pulses after a capacitive isolation is impossible when using square or sinusoidal pulses. Indeed, when using square pulses, the high pass filter will always transmit a fast rising edge followed by a fast falling edge and so on, making it impossible to transmit successive data peaks of same orientation.

The sawtooth signal's logic value is defined by the orientation of the fast edge of the sawtooth signal. For example, a fast rising edge will define a logical 1 when a fast falling edge will define a logical 0. On a first channel **71** the sawtooth signal has the same logic value than said input signal **D,** such that said sawtooth signal at node **A1** has a fast falling edge followed by a slow rising edge when input signal **D** is 0 and a fast rising edge followed by a slow falling edge when input signal **D** is 1. On a second channel **72** the sawtooth signal has an opposite logic value than said input signal **D,** such that said sawtooth signal at node **A2** has a fast rising edge followed by a slow falling edge when input signal **D** is 0 and a fast falling edge followed by a slow rising edge when input signal **D** is 1.

When said first sawtooth signal is applied to node **A1,** said first sawtooth signal is filtered such that, at node **B1,** only fast transients of the said first sawtooth signal will form short pulses with large magnitude with orientation corresponding to the derivative of the input pulse. When a fast rising curve slope occurs at input node **A1,** a short positive pulse with large magnitude occurs at node **B1.** When a fast falling curve slope occurs at input node **A1,** a short negative pulse with large magnitude occurs at node **B1.** As the input signal is composed of sawtooth pulses, all fast edges are of same variation until the value of **D** is changed. As long as **D** is set to 1, sawtooth signal at node **A1** will be composed of fast rising edges followed by slow falling slopes such that at node **B1,** the filtering will produce successive short positive pulses with large magnitude followed by long and very small pulses of negative values as represented in **Fig.4b****.** When the value of **D** is changed to 0, the sawtooth signal at **A1** is composed of fast falling edges followed by slow rising slopes such that at node **B1,** the filtering will produce successive short negative pulses with large magnitude followed by long and very small pulses of positive values. The ratio of the duration of the fast falling/fast rising edges to the corresponding slow rising/slow falling edges is selected in order that the corresponding filtered pulse have sufficiently different amplitudes in order for the threshold comparators to transmit only when the differences between signals at nodes B1 and B2 are larger than a threshold. This ratio may be smaller than 1/2, 1/5 or even 1/10.

As the differential link 80 comprises two channels **71** and **72** of inversed logic, when a logic signal 1 is sent to the first line of the differential link, a logic signal 0 is sent to the second line of the differential link and when a logic signal 0 is sent to the first line of the differential link, a logic signal 1 is sent to the second line of the differential link. As a consequence, nodes **A1** and **A2,** respectively **B1** and **B2,** will receive signals of complementary logic values.

In case of unwanted parasitic signal injected on node B1 or node B2 producing a wrong information pulse due to surrounding electrical noise, the system will auto correct itself after a maximum time delay of one modulated signal period of time **T0** which is also the time between two fast edges of the sawtooth signals. This allows to drastically reduce the time during which the system may provide a wrong information.

Said sawtooth modulators **STM1 51** receives said first command signals **41.** It is configured for providing a first sawtooth signal at a node **A1,** output of **STM1.** Said first sawtooth signal at node **A1** is composed of a fast rising edge triggered by a rising edge of the clock signal **CLK,** followed by a slow falling edge when **D** equals 1 and is composed of a fast falling edge triggered by a rising edge of the clock signal **CLK,** followed by a slow rising edge, when **D** equals 0. The said second sawtooth modulator **STM2 52** is configured for receiving said second command signals **42,** and for providing a second sawtooth signal at a node **A2,** output of **STM2.** Said second sawtooth signal is composed of a fast falling edge triggered by a rising edge of the clock signal **CLK,** followed by a slow rising edge, when **D** equals 1 and a fast rising edge triggered by a rising edge of the clock signal **CLK,** followed by a slow falling edge, when D equals 0 such that the two said sawtooth signals provide data information of inversed logic.

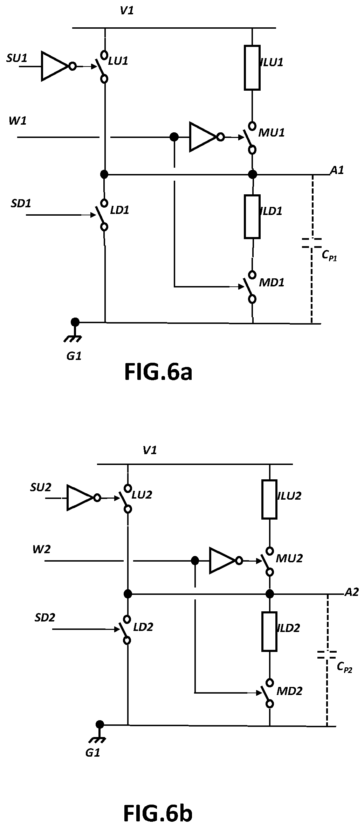

Sawtooth modulators **51** and **52** can be classically implemented for example but non exclusively, in CMOS technology, making use of transistors or micro-electromechanical switches as gates. A generic implementation using ideal switches or low-impedance switches is presented on figure **Fig.6a** and **6b****.**

In order to generate a sawtooth signal at node **A1,** said first sawtooth modulator **STM1 51,** represented on **Fig.3a** **and on** **Fig.6a****,** may comprise
- a first low impedance controllable switch **LU1** connected between a first power supply voltage **V1** and said output node **A1,** being closed when command signal **SU1** is equal to 0 and open otherwise;
- a second low impedance controllable switch **LD1** connected between said node **A1** and said first ground **G1,** being closed when command signal **SD1** is equal to 1 and open otherwise;
- a first controllable switch **MU1** in series with a current limiting dipole **ILU1** connected between said first power supply voltage **V1** and said node **A1,** said first controllable switch **MU1** being open when command signal **W1** is equal to 1 and closed otherwise;
- a second controllable switch **MD1** in series with a current limiting dipole **ILD1,** connected between said node **A1** and said first ground **G1,** second controllable switch being closed when command signal **W1** is equal to 1 and open otherwise;
- a capacitor **Cp1** between said node **A1** and ground **G1.**

The current limiting dipoles **ILU1** and **ILD1** may either be current sources or resistors or a combination thereof. The values of these components and of the capacitor **Cp1** are such that within the slow rising or falling edge, the sawtooth signals reaches at least 80% of **V1** or reaches less than 20% of **V1** respectively. In a specific embodiment, **Cp1** can be either a specific capacitor or a parasitic capacitance resulting from the technology used. A parasitic capacitance may result, e.g. from the circuit layout, the assembly such as bonding or connection.

To generate a fast rising edge of a sawtooth signal at node **A1, SU1** is set to close said switch **LU1** such that the capacitance **Cp1** is promptly charged to **V1** through **LU1,** while **SD1** is set to open switch LD1.

To generate a slow rising edge of a sawtooth signal, **W1** is set to close said switch **MU1** such that the capacitance **Cp1** is charged to **V1** through **MU1** and **ILU1,** while **SD1** is set to open **LD1** and **SU1** is set to open **LU1.**

To generate a fast falling edge of a sawtooth signal, **SD1** is set to close said switch **LD1** such that the capacitance **Cp1** promptly discharge to ground **G1** through **LD1** while **SU1** is set to open switch **LU1.**

To generate a slow falling edge of a sawtooth signal, **W1** is set to close said switch **MD1** such that the capacitance **Cp1** is discharged to **G1** through **MD1 and ILD1,** while **SD1** is set to open **LD1** and **SU1** is set to open **LU1.**

In order to generate a sawtooth signal at node **A2,** said second sawtooth modulator **STM2 52,** represented on **Fig.3a** and **6b****,** may comprise
- a first low impedance controllable switch connected **LU2** between a first power supply voltage **V1** and said output node **A2,** being closed when command signal **SU2** is equal to 1 and open otherwise;
- a second low impedance **LD2** controllable switch connected between said node **A2** and said first ground **G1,** being closed when command signal **SD2** is equal to 0 and open otherwise;
- a first controllable switch **MU2** in series with a current limiting dipole **ILU2,** connected between said first power supply voltage **V1** and said node **A2,** said first controllable switch being open when command signal **W2** is equal to 1 and closed otherwise;
- a second controllable switch **MD2** in series with a current limiting dipole **ILD2,** connected between said node **A2** and said first ground **G1,** second controllable switch being closed when command signal **W2** is equal to 1 and open otherwise;
- a capacitor **Cp2** between said node **A2** and ground **G1.**

The current limiting dipoles **ILU2** and **ILD2** may either be current sources or resistors or a combination thereof. The values of these components and of the capacitor **Cp2** are such that within the slow rising or falling edge, the sawtooth signals reaches at least 80% of **V1** or is less than 20% of **V1** respectively. In a specific embodiment, **Cp2** can be either a specific capacitor or a parasitic capacitance from a technology. A parasitic capacitance may result, e.g. from the circuit layout, the assembly such as bonding or connection.

To generate a fast rising edge of a sawtooth signal at node **A2, SU2** is set to close said switch **LU2** such that the capacitance **Cp2** is promptly charged to **V1** through **LU2,** while **SD2** set to open switch **LD2.**

To generate a slow rising edge of a sawtooth signal, **W2** is set to close said switch **MU2** such that the capacitance **Cp2** is charged to **V1** through **MU2 and ILU2,** while **SD2** is set to open **LD2** and **SU2** is set to open **LU2.**

To generate a fast falling edge of a sawtooth signal, **SD2** is set to close said switch **LD2** such that the capacitance **Cp2** promptly discharge to ground **G1** through **LD2** while **SU2** is set to open switches **LU2.**

To generate a slow falling edge of a sawtooth signal, **W2** is set to close said switch **MD2** such that the capacitance **Cp2** is discharged to **G1** through **MD2 and ILD2,** while **SD2** is set to open **LD2** and **SU2** is set to open **LU2.**

A first threshold comparator **121** having a first input connected to said node **B1,** and a second input connected to said node **B2,** produces a logical 1 output **S** when the difference between the value of its first input exceeds its second input by a threshold **Th1,** and logical 0 output otherwise such that only positive **B1-B2** pulses larger than the threshold **Th1** will generate a logical 1 pulse at output **S.**

A second threshold comparator **122** having a first input connected to said node **B2,** and a second input connected to said node **B1,** produces a logical 1 output **R** when its first input exceeds its second input by a threshold **Th2,** and a logical 0 output otherwise such that only positive **B2-B1** pulses larger than the threshold **Th2** will generate la logical 1 pulse at the output **R.** These two threshold comparators allow to obtain non interleaved successive digital pulses at a frequency of the clock signal CLK, only on output **S** when input signal **D** is set to logic 1 and only on output **R** when input signal is set to 0. This allows the system to be set in the correct mode according to the channel **S** or **R** from where the fast output signal comes from. In case of large interferences at B1 or B2, if a wrong information is generated on output S or output R, the system corrects itself at the maximum time of a clock period after the end of the fast parasitic transient. A parasitic is considered large when it can induce a differential voltage large enough to toggle comparators **121** or **122.** In case of moderate parasitic at node B1 or node B2, the system will filter the wrong information aimed to the high-pass filters and will not take into account the wrong information making the system robust to moderate interferences on B1 or B2.

**Fig.4a** represents typical signals at nodes **A1** and **A2** of the isolator of Fig. 3a or 3b, in dependence of the clock signal **CLK,** when digital signal D equals 0. Referring to Fig.6a and Table I hereunder, when the clock signal rises (second line of table 1, D=0, CLK=1), signal A1 undergoes a strong down movement, the capacitor C_{P1} being unloaded through closed switch LD1. The duration T1 of this down transition is very short because the resistance of the discharge circuit, including LD1 is low. Then, when the clock signal remains on (Tₒₙ), A1 remains low (Ground G1) in a plateau for a duration T2. When the clock signal goes to 0 (first line of table I hereunder, D=0, CLK=0), the signal at **A1** undergoes a slow rising edge for a duration T3. This duration is determined by the charge of capacitor Cp1, across current limiting dipole **ILU1.** When current limiting dipole **ILU1** is a resistor, the curve is the well known charge curve of an RC circuit. When the signal at A1 reaches at least 80% of V1, it may remain at this level or increase more for a duration T4 of a plateau until next rise of the clock signal. Similar transitions occur at node A2, with similar timings T1', T2', T3', T4' whose values may depend on the components of sawtooth modulator 52 of Fig.6b. The parameters of these circuits are selected in order that the durations of the fast falling edge T1, fast rising edge T1' are significantly shorter than the durations of the slow rising edge T3 and slow falling edge T3', respectively. This may be performed by adjusting the value of a resistor for ILU1 and ILU2 or of capacitors Cₚ₁ and Cₚ₂. Also the period of the clock T₀ and the pulse width Tₒₙ may be selected in order that enough time is given during period T3 for the signal A1 to rise to at least 80% of V1 before the next clock pulse occurs.

**Fig.4b** represents typical data pulses used to carry information at specific nodes of the circuit of **Fig.3****.** For clarity, the signals represented relate to a case where the rising/falling edges are very fast (T1 and T1' nearly zero), The clock pulse width Ton, very short (T2 nearly zero) and T4 nearly zero. Input signal **D** is a classical square digital signal carrying the information to be transmitted through the digital isolator. Specific sawtooth signal at node **A1** is used to transmit information through the isolation capacitor **61** and sawtooth signal at node **A2** is used to transmit information through the isolation capacitor **62.** Particular signals are found at node **B1** and **B2** corresponding respectively to signals at node **A1** and **A2** filtered by the high pass filters **91** and **92.** As shown on **Fig.4b****,** the signal at node **B1** is composed of successive pulses with a frequency corresponding to the clock frequency of the clock signal **CLK.** These pulses are positive with large magnitude when digital signal **D** is set to logic 1 and negative with large magnitude when digital signal **D** is set to logical 0. The signal at node **B2** is composed of successive pulses with a frequency corresponding to the clock frequency of the clock signal **CLK.** These pulses are negative with large magnitude when digital signal **D** is set to logic 1 and positive with large magnitude when digital signal **D** is set to logical 0. At the output of the threshold comparator **121,** only the difference between signals at nodes **B1** and **B2** that is greater than the threshold **Th1** is transmitted at node **S** and at the output of the threshold comparator **122,** only the difference between signals at nodes **B2** and **B1** that is greater than the threshold **Th2** is transmitted at node **R** such that pulses appear at node **S** only when said input signal **D** is set to logical 1 and pulses appear at node **R** only when said input signal **D** is set to logical 0 such that the two signals S and R are not interleaved.

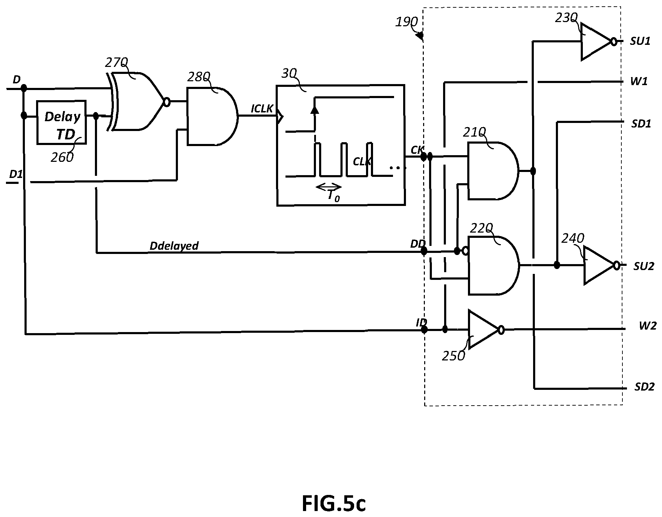

**Fig.5a, 5b,****5c** are embodiments of said logic module **20** for use in a digital insulator according to embodiments of the invention.

Said logic module **20** is composed of a clock generator **30** with an output delivering a clock signal **CLK** at node **CK** and a command interface **CMD 190** for receiving digital signals at input nodes **DD, CK** and **ID.** Node **ID** is for receiving said input signal **D.**

Said command interface **CMD 190** is composed of:
- a first AND gate **210** with a first input connected to node **CK** and with a second input connected to node **DD** and an output connected to the input node **SD2** of STM2 **52.**
- a first inverter **230** with input connected to the output of said first AND gate **210** and output connected to the input node **SU1** of STM1 **51.**
- a second AND gate **220** with a first inverted input connected to node **DD** and with a second non-inverted input connected to node **CK,** and an output connected to the input node **SD1** of STM1 **51.**
- a second inverter **240** with input connected to the output of said second AND gate **220** and output connected to **SU2** of STM2 **52.**
- a third inverter **250** with input connected to node **ID** and output connected to input node **W2** of STM2 **52,**
- said node **ID** is connected to input **W1** of said STM1 **51.**

In the first embodiment presented in **Fig.5a,** said nodes **DD** and **ID** are connected to the input of the digital isolator for receiving digital signal **D.** In this case, digital output signal **S** and **R** are not synchronized with the input signal **D.** After demodulation of the output signals **S** and **R,** for example by using an RS gate, the demodulated signal will present a small delay and a jitter.

In the first embodiment presented in **Fig.5a,** said logic module **20** is configured for providing first command signals to said first sawtooth modulator STM1 **51,** said first command signals comprising logical signals **SU1, SD1** and **W1,** and for providing second command signals to said second sawtooth modulator STM2 **52,** said second command signals comprising logical signals **SU2, SD2** and **W2**
- **SU1** being equal to 1 when **D** is equal to 0 and equal to the inverse of the clock signal otherwise;
- **SD1** being equal to the clock signal **CLK,** when **D** is equal to 0 and equal to 0 otherwise;
- **W1** is equal to 0 or equal to **CLK** when D equals 0 and is equal to 1 or equal to **not(CLK)** when D equals 1.
- **SU2** is equal to not**(SD1);**
- **SD2** is equal to not**(SU1)**
- **W2** is equal to not(**W1**).
This command logic is summarized in the following table:

**Table I**

| **D** | **CLK** | **SU1 (S̅D̅2̅ )** | **SD1 (S̅U̅2̅ )** | **W1 (W̅2̅ )** |
|---|---|---|---|---|
| 0 | 0 | 1 | 0 | 0 |
| 0 | 1 | 1 | 1 | X |
| 1 | 0 | 1 | 0 | 1 |
| 1 | 1 | 0 | 0 | X |

In said "anti-jitter" embodiment presented in **Fig.5b,** an anti-jitter solution is proposed characterized in that said logic module **20** comprises means for disabling the clock generator **30** at a transition of the digital signal **D,** and for re-enabling synchronously the clock generator after a delay **TD** afterwards. Such disabling is performed for downward and upward transitions of digital signal D. The delay TD is preferably larger than 0.5*T0, e.g. 0.6 or 0.7*T0, and more preferably larger than 0.8*T0.

In this anti-jitter embodiment, said logic module **20** is composed of :
- a clock generator **30** with an output delivering a clock signal **CLK** at node **CK.** Said clock generator **30** has a clock enabling input **ICLK** enabling clock pulses **CLK** when the digital input at input **ICLK** is set to logical 1 and disabling clock pulses **CLK** when the digital input at input **ICLK** is set to logical 0.
- a command interface **CMD 190** for receiving digital signals at input nodes **DD, CK** and **ID** and providing logical signals **SU1, SD1, W1, SU2, SD2** and **W2,**
- a delay line 260 having an input connected to the input of the digital isolator for receiving signal **D** and an output connected to node DD and providing an output signal **Ddelayed** composed of the input signal at node **D** delayed by a time delay TD,
- an XNOR gate **270** having the output connected to input **ICLK** of said clock generator 30 and first input connected to node **DD** and a second input connected to the output of said delay line **260,**
- said node **ID** is connected to the input of the digital isolator for receiving digital signal **D.**

In this anti-jitter embodiment, said logic module **20** is configured for providing first command signals to said first sawtooth modulator STM1 **51,** said first command signals comprising logical signals **SU1, SD1** and **W1,** and for providing second command signals to said second sawtooth modulator STM2 **52,** said second command signals comprising logical signals **SU2, SD2** and **W2,** said logical module comprising means for determining a digital signal Ddelayed, being digital signal **D** delayed by a duration equal to or longer than 0.8*T0
- **SU1** being equal to not(**CLK**) when **D** equals 1 and **Ddelayed** equals 1, and **SU1** being equal to 1 otherwise;
- **SD1** being equal to the clock signal **CLK,** when **D** is equal to 0 and **Ddelayed** is equal to 0, and SD1 being equal to 0 otherwise;
- **W1** being equal to 0 or equal to **CLK** when **D** equals 0 and **Ddelayed** is equal to 0, **W1** being equal to 1 or equal to not**(CLK)** when **D** equals 1 and **Ddelayed** equals 1, **W1** being equal to 0 when **D** equals 0 and **Ddelayed** is equal to 1, **W1** being equal to 1 when **D** equals 1 and **Ddelayed** equals 0;
- **SU2** is equal to not(**SD1**),
- **SD2** is equal to not(**SU1**)
- **W2** is equal to not(**W1**).

In embodiment of **FIG.5b,** input data **D** is internally delayed by a delay **TD** equal to or larger than **T0***0.8 to define a preset time lapse whenever the state of **D** is toggling. During this preset time lapse, signals at node **A1** and node **A2** are preset to the correct initial state without applying any fast transition during this preset time lapse. At time **TD** after an input data change, the correct sawtooth signal fast transient can be applied on nodes **A1** and **A2.** This introduces a constant delay of about **TD** in the transmission, but the jitter is reduced to close to zero on demodulated **S** and **R** signals with reference to the input data **D.**
This command logic is summarized in the following table:

**Table II**

| **D** | **Ddelayed** | **CLK** | **SU1 (S̅D̅2̅ )** | **SD1 (S̅U̅2̅ )** | **W1 (W̅2̅ )** |
|---|---|---|---|---|---|
| 0 | 0 | 0 | 1 | 0 | 0 |
| 0 | 0 | 1 | 1 | 1 | X |
| 1 | 1 | 0 | 1 | 0 | 1 |
| 1 | 1 | 1 | 0 | 0 | X |
| 0 | 1 | 0 | 1 | 0 | 0 |
| 0 | 1 | 1 | 1 | 0 | 0 |
| 1 | 0 | 0 | 1 | 0 | 1 |
| 1 | 0 | 1 | 1 | 0 | 1 |

In the "selector" embodiment presented in **Fig.5c****,** said logic module **20** is adapted for receiving a second digital signal **D1** characterized in that said logic module **20** may comprise additional means for disabling the clock generator **30** when additional digital signal **D1** is equal to logical 0.

In this "selector" embodiment, an additional digital signal **D1,** with reference to a first ground **G1,** is used as input digital signal, and said input signal **D,** with reference to said first ground **G1,** is used as a selector for sending a corresponding signal of said additional digital signal **D1** on output **R** or output **S,** with reference to a second ground **G2,** depending on the logic value of said signal **D.**

In this "selector" embodiment presented in **Fig.5c****,** said logic module **20** is composed of:
- a clock generator 30 with an output delivering a clock signal **CLK** at node **CK.** Said clock generator 30 has a clock enabling input **ICLK** enabling clock pulses **CLK** when the digital input at input **ICLK** is set to logical 1 and disabling clock pulses **CLK** when the digital input at input **ICLK** is set to logical 0.
- a command interface CMD 190 for receiving digital signals at input nodes **DD, CK** and **ID** and providing logical signals **SU1, SD1, W1, SU2, SD2 and W2,**
- a delay line 260 having an input connected to the input of the digital isolator for receiving signal **D** and an output connected to node **DD** and providing an output signal **Ddelayed** composed of the input signal at node **D** delayed by a time delay **TD,**
- an XNOR gate 270 having a first input connected to the input of the digital isolator for receiving digital signal **D,** and a second input connected to the output of said delay line 260,
- said node **DD** is connected to the output of said delay line 260,
- a third AND gate 280 having a first input connected to the output of the XNOR gate 270 and a second input connected to the second input of the digital isolator for receiving additional digital signal **D1,** and an output connected to input **ICLK** of said clock generator 30.

In this third embodiment presented in **Fig.5c****,** said logic module is configured for providing first command signals to said first sawtooth modulator **STM1,** said first command signals comprising logical signals **SU1, SD1** and **W1,** and for providing second command signals to said second sawtooth modulator **STM2,** said second command signals comprising logical signals **SU2, SD2** and **W2,** said logical module comprising means for determining a digital signal **Ddelayed,** being digital signal **D** delayed by a duration equal to or longer than **TD** = 0.8***T0**;
- **SU1** being equal to not(**CLK**) when **D** equals 1, **Ddelayed** equals 1 and **D1** equals 1, and **SU1** being equal to 1 otherwise;
- **SD1** being equal to the clock signal **CLK,** when **D** is equal to 0, **Ddelayed** is equal to 0 and **D1** equals 1, and **SD1** being equal to 0 otherwise;
- **W1** being equal to 0 or equal to **CLK** when D equals 0, **Ddelayed** equals 0, and **D1** equals 1, **W1** being equal to 1 or equal to not(**CLK**) when **D** equals 1, **Ddelayed** equals 1, and **D1** equals 1, **W1** being equal to 0 when D equals 0, **Ddelayed** equals 0, and **D1** equals 0, **W1** being equal to 1 when **D** equals 1, **Ddelayed** equals 1 and **D1** equals 0;
- **SU2** is equal to not(**SD1**);
- **SD2** is equal to not(**SU1**);
- **W2** is equal to not(**W1**).
This command logic is summarized in the following table:

**Table III**

| **D1** | **D=Ddelayed** | **CLK** | **SU1 (S̅D̅2̅ )** | **SD1 (S̅U̅2̅ )** | **W1 (W̅2̅ )** |
|---|---|---|---|---|---|
| 1 | 0 | 0 | 1 | 0 | 0 |
| 1 | 0 | 1 | 1 | 1 | X |
| 1 | 1 | 0 | 1 | 0 | 1 |
| 1 | 1 | 1 | 0 | 0 | X |
| 0 | 0 | 0 | 1 | 0 | 0 |
| 0 | 0 | 1 | 1 | 0 | 0 |
| 0 | 1 | 0 | 1 | 0 | 1 |
| 0 | 1 | 1 | 1 | 0 | 1 |

In this third embodiment presented in **Fig.5c****,** the same function than in the case of the second embodiment of **Fig.5b** is obtained when **D1** is set to a constant logical 1. The same function than in the case of the first embodiment of **Fig.5a** is obtained when **D1** is set to a constant logical 1 and when the delay time **TD** is set to 0.

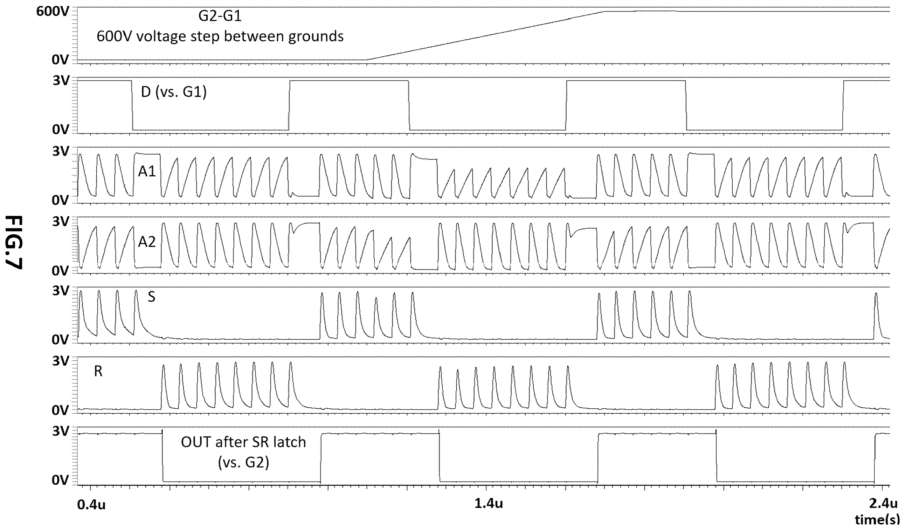

**Fig.7** show results of simulation of the anti-jitter embodiment of the invention. A 600 V linear increase of the voltage of **G2** with respect to **G1** between times 1.1 µs and 1.7 µs. Input signal **D,** between 0 V and 3 V with respect to ground **G1,** is transmitted without error to signal OUT, with constant delay TD, between 0 V and 3 V with respect to ground **G2.**

As is well known to the skilled person, the low impedance controllable switches, and medium impedance controllable switches used in the invention may be implemented in various ways, such, for example with MOSFETS, bipolar or any other kind of transistors or any kind of device that can modulate a conduction channel or any mechanical switching .

## Claims

1. A digital isolator (10) comprising:
- a logic module circuit (20) arranged to receive a digital signal D, and to generate corresponding first (41) and second (42) command signals, wherein the logic module circuit (20) is referenced to a first ground G1;
- a first sawtooth modulator circuit (51) referenced to the first ground G1 and arranged to receive the first command signal (41), and in response generate a first sawtooth signal at a first node A1, wherein the first sawtooth signal has a fast rising edge followed by a slow falling edge when the digital signal equals 1, and the first sawtooth signal has a fast falling edge followed by a slow rising edge when the digital signal equals 0;
- a second sawtooth modulator circuit (52) referenced to the first ground G1 and arranged to receive the second command signal (42), and in response generate a second sawtooth signal at a second node A2, wherein the second sawtooth signal has a fast falling edge followed by a slow rising edge when the digital signal equals 1, and a fast rising edge followed by a slow falling edge when the digital signal equals 0; and
- a first isolation capacitor (61) coupled to the first sawtooth modulator circuit (51) at the first node A1 and to a first input terminal of an output circuit at a third node B1; and
- a second isolation capacitor (62) coupled to the second sawtooth modulator circuit (52) at the second node A2 and to a second input terminal of the output circuit at a fourth node B2; wherein the output circuit is referenced to a second ground G2 and is arranged to generate an output signal OUT corresponding to the digital signal D, wherein a fast rising edge has a higher rate of signal change with respect to time than a slow rising edge, and wherein a fast falling edge has a higher rate of signal change with respect to time than a slow falling edge,
the digital isolator (10) further comprising a first impedance element (101) coupled between the third node B1 and a bias voltage source (110) referenced to the second ground G2 and a second impedance element (102) coupled between the fourth node B2 and the bias voltage source (110) wherein the output circuit comprises a first comparator (121) having a first input connected to the third node B1 and a second input connected to the fourth node B2, wherein the first comparator (121) is arranged to generate a logical 1 output when a voltage at its first input exceeds a voltage at its second input by a first threshold, and a logical 0 output otherwise and wherein the output circuit comprises a second comparator (122) having a first input connected to the fourth node B2 and a second input connected to the third node B1, wherein the second comparator (122) is arranged to generate a logical 1 output when a voltage at its first input exceeds a voltage at its second input by a second threshold, and a logical 0 output otherwise.

2. The digital isolator (10) of claim 1, wherein durations of slow rising edges and/or of slow falling edges at the first and second nodes are at least two times durations of corresponding fast falling edges and/or fast rising edges, respectively.

3. The digital isolator (10) of claim 1, wherein a clock signal having a period T0 has a pulse width shorter than T0/3.

4. The digital isolator (10) of claim 1, wherein the logic module circuit (20) comprises means for disabling a clock generator (30) at a transition of the digital signal, and to reenabling the clock generator (30) after a delay TD.

5. The digital isolator (10) of claim 4, wherein delay TD is larger than 0.5*T0, 0.6*T0, 0.7*T0 ,0.8*T0 or T0.

## Patentansprüche

1. Digitaler Isolator (10), der Folgendes umfasst:
- eine Logikmodulschaltung (20), die dazu ausgelegt ist, ein digitales Signal D zu empfangen und ein entsprechendes erstes (41) und ein entsprechendes zweites (42) Befehlssignal zu erzeugen, wobei die Logikmodulschaltung (20) auf eine erste Masse G1 bezogen ist;
- eine erste Sägezahnmodulatorschaltung (51), die auf die erste Masse G1 bezogen ist und dazu ausgelegt ist, das erste Befehlssignal (41) zu empfangen und als Reaktion darauf ein erstes Sägezahnsignal an einem ersten Knoten A1 zu erzeugen, wobei das erste Sägezahnsignal eine schnell steigende Flanke gefolgt von einer langsam fallenden Flanke aufweist, wenn das digitale Signal gleich 1 ist, und das erste Sägezahnsignal eine schnell fallende Flanke gefolgt von einer langsam steigenden Flanke aufweist, wenn das digitale Signal gleich 0 ist;
- eine zweite Sägezahnmodulatorschaltung (52), die auf die erste Masse G1 bezogen ist und dazu ausgelegt ist, das zweite Befehlssignal (42) zu empfangen und als Reaktion darauf ein zweites Sägezahnsignal an einem zweiten Knoten A2 zu erzeugen, wobei das zweite Sägezahnsignal eine schnell fallende Flanke gefolgt von einer langsam steigenden Flanke aufweist, wenn das digitale Signal gleich 1 ist, und eine schnell steigende Flanke gefolgt von einer langsam fallenden Flanke aufweist, wenn das digitale Signal gleich 0 ist; und
- einen ersten Isolationskondensator (61), der an dem ersten Knoten A1 mit der ersten Sägezahnmodulatorschaltung (51) und an einem dritten Knoten B1 mit einem ersten Eingangsanschluss einer Ausgangsschaltung gekoppelt ist; und
- einen zweiten Isolationskondensator (62), der an dem zweiten Knoten A2 mit der zweiten Sägezahnmodulatorschaltung (52) und an einem vierten Knoten B2 mit einem zweiten Eingangsanschluss der Ausgangsschaltung gekoppelt ist;
wobei die Ausgangsschaltung auf eine zweite Masse G2 bezogen ist und dazu ausgelegt ist, ein Ausgangssignal OUT zu erzeugen, das dem digitalen Signal D entspricht, wobei eine schnell steigende Flanke eine höhere Rate der Signaländerung in Bezug auf die Zeit als eine langsam steigende Flanke aufweist und wobei eine schnell fallende Flanke eine höhere Rate der Signaländerung in Bezug auf die Zeit als eine langsam fallende Flanke aufweist,
wobei der digitale Isolator (10) ferner ein erstes Impedanzelement (101), das zwischen dem dritten Knoten B1 und einer auf die zweite Masse G2 bezogenen Vorspannungsquelle (110) gekoppelt ist, und ein zweites Impedanzelement (102), das zwischen dem vierten Knoten B2 und der Vorspannungsquelle (110) gekoppelt ist, umfasst, wobei die Ausgangsschaltung einen ersten Komparator (121) mit einem mit dem dritten Knoten B1 verbundenen ersten Eingang und einem mit dem vierten Knoten B2 verbundenen zweiten Eingang umfasst, wobei der erste Komparator (121) dazu ausgelegt ist, eine logische Ausgabe von 1 zu erzeugen, wenn eine Spannung an seinem ersten Eingang eine Spannung an seinem zweiten Eingang um einen ersten Schwellenwert überschreitet, und andernfalls eine logische Ausgabe von 0 zu erzeugen, und wobei die Ausgangsschaltung einen zweiten Komparator (122) mit einem mit dem vierten Knoten B2 verbundenen ersten Eingang und einem mit dem dritten Knoten B1 verbundenen zweiten Eingang umfasst, wobei der zweite Komparator (122) dazu ausgelegt ist, eine logische Ausgabe von 1 zu erzeugen, wenn eine Spannung an seinem ersten Eingang eine Spannung an seinem zweiten Eingang um einen zweiten Schwellenwert überschreitet, und andernfalls eine logische Ausgabe von 0 zu erzeugen.

2. Digitaler Isolator (10) nach Anspruch 1, wobei Dauern langsam steigender Flanken und/oder langsam fallender Flanken an dem ersten und dem zweiten Knoten mindestens das Doppelte von Dauern entsprechender schnell fallender Flanken bzw. schnell steigender Flanken betragen.

3. Digitaler Isolator (10) nach Anspruch 1, wobei ein Taktsignal mit einer Periode T0 eine Pulsbreite aufweist, die kürzer als T0/3 ist.

4. Digitaler Isolator (10) nach Anspruch 1, wobei die Logikmodulschaltung (20) Mittel zum Deaktivieren eines Taktgenerators (30) bei einem Übergang des digitalen Signals und zum erneuten Aktivieren des Taktgenerators (30) nach einer Verzögerung TD umfasst.

5. Digitaler Isolator (10) nach Anspruch 4, wobei die Verzögerung TD größer als 0,5*T0, 0,6*T0, 0,7*T0, 0,8*T0 oder T0 ist.

## Revendications

1. Un isolateur numérique (10) comprenant :
- un circuit de module logique (20) agencé pour recevoir un signal numérique D et pour générer des premier (41) et deuxième (42) signaux de commande correspondants, dans lequel le circuit de module logique (20) est référencé à une première masse G1 ;
- un premier circuit modulateur en dents de scie (51) référencé à la première masse G1 et agencé pour recevoir le premier signal de commande (41), et générer en réponse un premier signal en dents de scie au niveau d'un premier nœud A1, dans lequel le premier signal en dents de scie a un front montant rapide suivi d'un front descendant lent lorsque le signal numérique est égal à 1, et le premier signal en dents de scie a un front descendant rapide suivi d'un front montant lent lorsque le signal numérique est égal à 0 ;
- un deuxième circuit modulateur en dents de scie (52) référencé à la première masse G1 et agencé pour recevoir le deuxième signal de commande (42), et générer en réponse un deuxième signal en dents de scie au niveau d'un deuxième nœud A2, dans lequel le deuxième signal en dents de scie présente un front descendant rapide suivi d'un front montant lent lorsque le signal numérique est égal à 1, et un front montant rapide suivi d'un front descendant lent lorsque le signal numérique est égal à 0 ; et
- un premier condensateur d'isolation (61) couplé au premier circuit modulateur en dents de scie (51) au niveau du premier nœud A1 et à une première borne d'entrée d'un circuit de sortie au niveau d'un troisième nœud B1 ; et
- un deuxième condensateur d'isolation (62) couplé au deuxième circuit modulateur en dents de scie (52) au niveau du deuxième nœud A2 et à une deuxième borne d'entrée du circuit de sortie au niveau d'un quatrième nœud B2 ;
dans lequel le circuit de sortie est référencé à une deuxième masse G2 et est agencé pour générer un signal de sortie OUT correspondant au signal numérique D, dans lequel un front montant rapide a un taux de variation de signal plus élevé par rapport au temps qu'un front montant lent, et dans lequel un front descendant rapide a un taux de variation de signal plus élevé par rapport au temps qu'un front descendant lent,
l'isolateur numérique (10) comprenant en outre un premier élément d'impédance (101) couplé entre le troisième nœud B1 et une source de tension de polarisation (110) référencée à la deuxième masse G2 et un deuxième élément d'impédance (102) couplé entre le quatrième nœud B2 et la source de tension de polarisation (110), dans lequel le circuit de sortie comprend un premier comparateur (121) ayant une première entrée connectée au troisième nœud B1 et une deuxième entrée connectée au quatrième nœud B2, dans lequel le premier comparateur (121) est agencé pour générer une sortie logique 1 lorsqu'une tension à sa première entrée dépasse une tension à sa deuxième entrée d'un premier seuil, et une sortie logique 0 dans le cas contraire, et dans lequel le circuit de sortie comprend un deuxième comparateur (122) ayant une première entrée connectée au quatrième nœud B2 et une deuxième entrée connectée au troisième nœud B1, dans lequel le deuxième comparateur (122) est agencé pour générer une sortie logique 1 lorsqu'une tension à sa première entrée dépasse une tension à sa deuxième entrée d'un deuxième seuil, et une sortie logique 0 dans le cas contraire.

2. L'isolateur numérique (10) selon la revendication 1, dans lequel les durées des fronts montants lents et/ou des fronts descendants lents au niveau des premier et deuxième nœuds sont au moins deux fois plus longues que les durées des fronts descendants rapides et/ou des fronts montants rapides correspondants, respectivement.

3. L'isolateur numérique (10) selon la revendication 1, dans lequel un signal d'horloge ayant une période T0 a une largeur d'impulsion inférieure à T0/3.

4. L'isolateur numérique (10) selon la revendication 1, dans lequel le circuit de module logique (20) comprend des moyens pour désactiver un générateur d'horloge (30) lors d'une transition du signal numérique, et pour réactiver le générateur d'horloge (30) après un retard TD.

5. L'isolateur numérique (10) selon la revendication 4, dans lequel le retard TD est supérieur à 0,5*T0, 0,6*T0, 0,7*T0, 0,8*T0 ou T0.
